Europäisches Patentamt

European Patent Office

Office européen des brevets

(11) Publication number : **0 495 653 A1**

# (12) EUROPEAN PATENT APPLICATION

(21) Application number : **92300360.2**

(22) Date of filing : **16.01.92**

(51) Int. Cl.⁵ : **H03G 3/32, G11B 19/02, G11B 33/10**

(30) Priority : **16.01.91 ZA 910329**
**16.07.91 ZA 915564**

(43) Date of publication of application :
**22.07.92 Bulletin 92/30**

(84) Designated Contracting States :
**AT BE CH DE DK ES FR GR IT LI LU MC NL PT SE**

(71) Applicant : **SOUNDOUT (PTY) LTD.**
**Southern Life Place, Riebeek Street**
**Cape Town, Cape Province (ZA)**

(72) Inventor : **Smiedt, Leslie**
**5 Vesperdene Mews, Vesperdene Road**
**Green Point, Cape Province (ZA)**

(74) Representative : **Opperman, Stuart Richard et al**
**Haseltine Lake & Co. Hazlitt House 28**
**Southampton Buildings Chancery Lane**
**London WC2A 1AT (GB)**

(54) **Audio equipment.**

(57) Audio equipment is disclosed which comprises a player (10), such as a portable compact disc player or a portable tape cassette player, and a set of earphones (16). The equipment includes a sound operated switch (30) which, when it responds to a sound at a level above its response level, alerts the user of the equipment that the sound has occurred. The switch can either interrupt the audio signal to the headphones, switch-off the player or superimpose a tone on the audio signal. The equipment ensures that a person wearing the earphones is alerted to a telephone ringing, a person speaking to him etc. The switch is preferably incorporated into a unit which can be connected between the player and the headphones.

FIG. 3

Jouve, 18, rue Saint-Denis, 75001 PARIS

## FIELD OF THE INVENTION

THIS INVENTION relates to audio equipment.

Portable compact disc players and portable tape cassette players usually include headphones. Additionally, many people prefer to listen to music from a Hi-Fi set through headphones rather than by way of speakers in the room. Modern headphones are so efficient at shutting out ambient sounds that the wearer of the headphones is in effect isolated from the world around him. Consequently the user does not hear someone speak to him, or a telephone ringing or a knock on the door.

The main object of the present invention is to provide audio equipment which does not have this disadvantage.

## SUMMARY OF THE INVENTION

According to one aspect of the present invention there is provided audio equipment which comprises a sound operated switch which is activated by an ambient sound which is above the response level of the switch, the switch being connected so that the output signal it produces on responding to said sound, alerts the person wearing the headphones that the switch has responded.

In one form said switch is connected so as to interrupt communication between the output of a player and the speakers of a set of headphones when said switch responds to a sound above its response level. In another form the equipment includes means for generating a tone which is applied to at least one of the speakers of a set of headphones upon said switch responding to a sound which is above its response level.

Said switch can if desired be connected so as to interrupt communication between the sound reproducing system of a player and an output jack of the player into which a set of headphones can be plugged.

A timer can be provided for resetting said sound operated switch after elapse of a predetermined period of time, and means can be provided for enabling said predetermined period of time to be adjusted.

According to a further aspect of the present invention there is provided a unit comprising a casing having an input for connection to a player, an output for connection to a set of headphones, and a sound operated switch in the casing for disconnecting said input from said output upon said switch being subjected to a sound above its response level.

Desirably the unit includes a timer for reconnecting said input to said output after elapse of a predetermined period of time. Means can be provided for adjusting said predetermined period of time. Said casing can include a grid behind which there is a microphone for picking up ambient sound. To enable the unit to be used in different environments there can be means for enabling the response level of the sound operated switch to be adjusted.

According to another aspect of the present invention there is provided audio equipment which comprises means for producing an electrical signal representing sound, a socket to which the signal is fed and into which socket a jack on a set of headphones can be plugged, and a sound operated switch connected between said means and said socket for breaking said connection upon the switch responding to an ambient sound which is above the response level of said switch.

Amplifier means can be provided for amplifying said electrical signal, the amplifier means being between said means for producing an electrical signal and said socket.

## BRIEF DESCRIPTION OF THE DRAWINGS

For a better understanding of the present invention, and to show how the same may be carried into effect, reference will now be made, by way of example, to the accompanying drawings in which:

Figure 1 is a diagram illustrating a set of headphones connected to a player;

Figure 2 is a diagram to a larger scale illustrating a modification of the set of headphones illustrated in Figure 1;

Figure 3 is a diagram illustrating a player, a set of headphones and a unit according to the present invention;

Figure 4 is a diagrammatic representation of the unit of Figure 1; and

Figure 5 is a diagrammatic representation of further audio equipment in accordance with the present invention.

## DESCRIPTION OF THE PREFERRED EMBODIMENTS

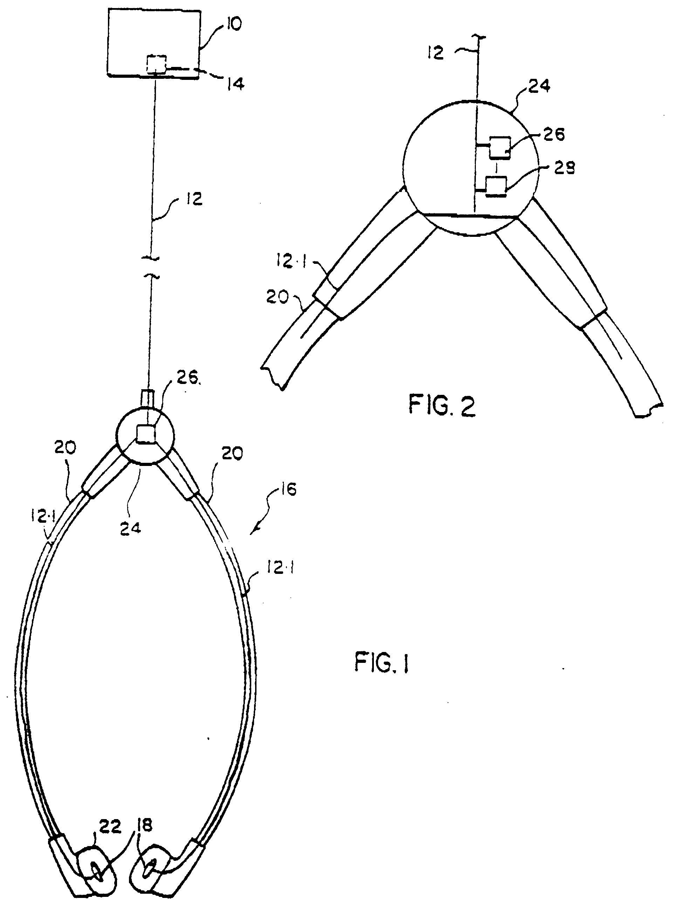

Referring firstly to Figure 1, the sound reproducing equipment illustrated comprises a tape cassette or compact disc player 10 which can be, but is not necessarily, of the portable type. A lead 12 runs from a socket 14 of the player 10 to a set of headphones designated 16. The headphones 16 include two speakers designated 18 which are mounted at the free ends of limbs designated 20. The speakers 18 are encircled by rings 22 that are of a material such as rubber, foamed synthetic plastics material or felt.

The arms 20 are resilient and, when the user of the headphones puts them on, he has to move the speakers 18 apart to be able to fit them on his ears. The resilient arms 20 urge the speakers 18 towards one another so that the rings 22 press on the wearer's ears and prevent ambient sound reaching the wearer's ears. Thus the only sounds reaching the wearer's ears are those generated in the speakers 18, and which are found on the cassette or compact disc which is in the player 10.

The arms 20 and the lead 12 all extend from a boss designated 24. Built into the boss 24 is a voice operated switch 26. As is shown diagrammatically in Figure 1, the voice operated switch 26 is between the lead 12 and the connections 12.1 which run from the boss 24 along the arms 20 to the speakers 18.

In the event of the sound operated switch 26 detecting sound at a level which is above its response level, the switch opens and interrupts communication between the player 10 and the speakers 18. Thus the user is alerted to the fact that there has been a loud sound in the environment. The loud sound might be someone speaking to him, the ringing of a telephone or door bell etc.

It is possible to provide a control (not shown in Figure 1) which enables the response level of the sound operated switch to be adjusted. Thus if the equipment is to be used in an environment where the ambient noise level is high, eg in the cabin of an aircraft, the switch can be desensitised so that it does not operate at the general noise level. For quiet places, the switch can be made more sensitive.

In the modification of Figure 2, the sound operated switch 26 is connected to a tone generator 28. The tone generator 28 is built into the boss 24 with the switch 26. When the sound operated switch 26 is actuated by a loud sound, it activates the tone generator which then produces a warning tone which is superimposed on the audio signal produced by the player 10. Thus the user of the headphones is alerted to the fact that a loud sound has occurred.

The sound operated switches 26 of Figures 1 and 2 can be provided with manual reset buttons. In the case of the embodimet of Figure 1, interruption of the audio signal continues until the voice operated switch is reset. In the case of the embodiment of Figure 2 the warning tone continues until the voice operated switch has been reset. Alternatively, a timer can be incorporated so that interruption of the audio signal, or superimposition of the tone, continues for a predetermined period only. A control can be provided for enabling the length of the predetermined period to be adjusted.

If desired the sound operated switch, the controls therefor and the tone generator (if provided) can be incorporated into the set of head phones immediately adjacent one of the speakers 22 instead of into the boss 24.

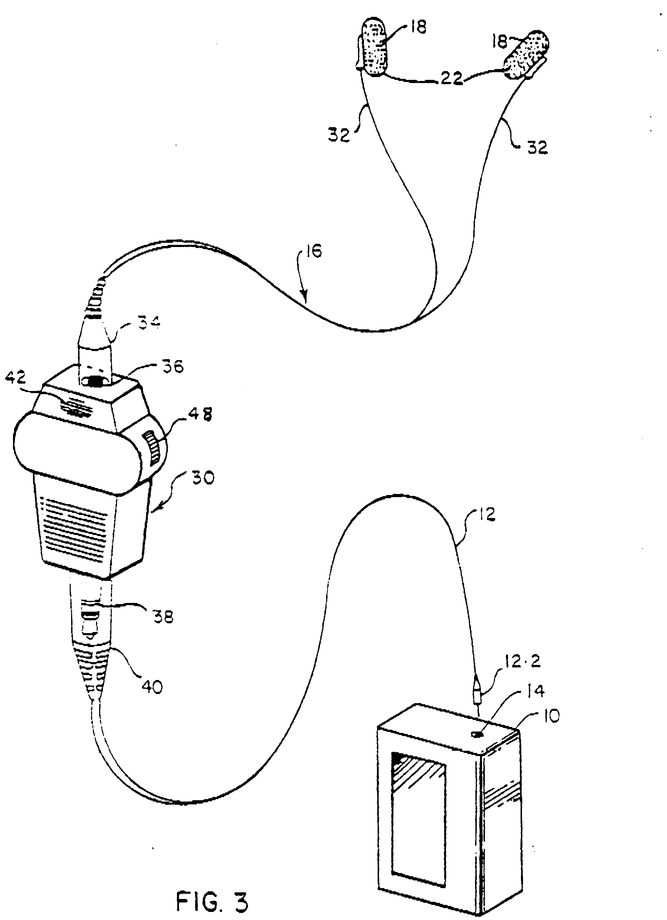

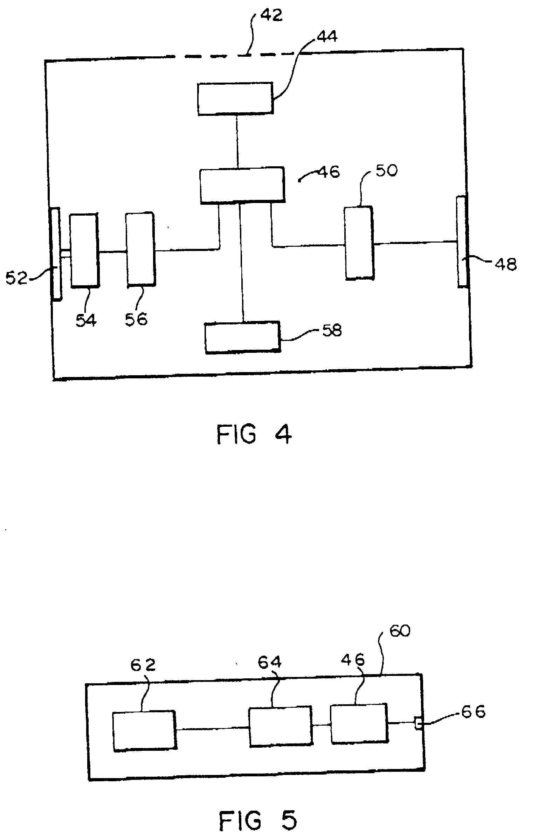

Turning now to Figures 3 and 4, the sound reproducing equipment illustrated in these Figures comprises a player 10 and a lead 12 which is illustrated so having a jack 12.2 at one end thereof. The jack 12.2 plugs into the socket 14 of the player 10 and the lead 12 runs to a unit which comprises a casing 30. The headphones 16 do not, in this form, include arms 20.

Instead, the speakers 18 and the rings 22 are secured to the ends of flexible leads 32 which extend from the speakers 18 to a jack 34 which plugs into a socket 36 of the casing 30. In the illustrated form the casing 30 has a protruding jack 38 which is inserted into a socket 40 at the end of the lead 12 remote from the jack 12.2 which plugs into the socket 14. In an alternative construction the lead 12, jack 12.2 and socket 40 are omitted and the jack 38 is plugged into the socket 14. The jack 38 can, instead of protruding from the casing 30, be at the end of a short lead.

The grid 82 in Figure 3 covers a microphone 44 (Figure 4) which picks up ambient sound and feeds the resulting signal to the sound operated switch 46. The rotatable wheel shown at 48 enables the sensitivity of the unit, ie the response level of the sound operated switch 46, to be adjusted. The means for adjusting sensitivity is in the form of a gain control 50. The degree of adjustment can be such that the response level can be raised to such a high level that the unit is effectively switched off. This enables the player 10 to be used without interruption even if there are loud ambient noises.

A further wheel 52 is provided on the opposite side of the casing 30 to the wheel 48 for enabling the control means 54 of a timer 56 to be adjusted. This enables the period for which signal interruption, or tone superimposition if a tone generator is used, continues to be varied by the user. Reference numeral 58 designates a speaker to which the tone signal is transmitted if a tone generator is used.

The sound operated switch can if desired be incorporated into the player (see Figure 5) instead of into the headphones (Figures 1 and 2) or into a separate unit (Figures 3 and 4). In Figure 5 reference numeral 60 designates a player which can be a radio receiver, a compact disc player, a tape cassette player, a record player, a digital tape player or any other device which produces electrical signals representing sound. Thus 62 designates a tuner, a tape cassette head, a compact disc pick-up, a stylus etc. Reference numeral 64 designates an amplifier and 66 a socket into which a jack on a set of headphones (not shown in Figure 5) can be plugged. The sound operated switch 46 is between the amplifier 64 and the socket 66.

It is also possible to use the sound operated switch to interrupt the power supply but such form is not considered as desirable as the forms described above.

It is also possible, in the event of a television set or monitor or a hand held computer game having headphones, to incorporate a sound operated switch between the headphone jack and the means that produces the audio signal.

## Claims

1. Audio equipment which comprises a sound operated switch which is activated by an ambient sound which is above the response level of the switch, the switch being connected so that the output signal it produces on responding to said sound, alerts a person wearing a set of headphones that the switch has responded.

2. Audio equipment according to claim 1, in which said switch is connected so as to interrupt communication between the output of a player and the speakers of a set of headphones upon said switch responding to a sound above its response level.

3. Audio equipment according to claim 1, and which includes means for generating a tone which is applied to at least one of the speakers of a set of headphones upon said switch responding to a sound which is above its response level.

4. Audio equipment according to claim 1, in which said switch is connected so as to interrupt communication between the sounding reproducing system of a player and an output jack into which the headphones can be plugged.

5. Audio equipment according to claim 1 and including a timer for resetting said sound operated switch after elapse of a predetermined period of time.

6. Audio equipment according to claim 5 in which means are provided for enabling said predetermined period of time to be adjusted.

7. A unit comprising a casing having an input for connection to a player, an output for connection to a set of headphone, and a sound operated switch in the casing for disconnecting said input from said output upon said switch being subjected to a sound above its response level.

8. A unit according to claim 7 and including a timer for reconnecting said input to said output after elapse of a predetermined period of time.

9. A unit according to claim 8, and including means for adjusting said predetermined period of time.

10. A unit according to claim 7, in which said casing includes a grid behind which there is a microphone for picking up ambient sound.

11. A unit according to claim 7 and which includes means for enabling the response level of the sound operated switch to be adjusted.

12. Audio equipment which comprises means for producing an electrical signal representing sound, a socket to which the signal is fed and into which socket a jack on a set of headphones can be plugged, and a sound operated switch connected between said means and said socket for breaking said connection upon the switch responding to an ambient sound which is above the response level of said switch.

13. Audio equipment according to claim 12 and including amplifier means for amplifying said electrical signal, the amplifier means being between said means for producing an electrical signal and said socket.

FIG. 2

FIG. I

FIG. 3

FIG 4

FIG 5

European Patent
Office

# EUROPEAN SEARCH REPORT

Application Number

EP    92 30 0360

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | EP-A-0 290 415 (STAAR SOCIETE ANONYME) * column 4, line 52 - line 65; claims 1-16; figures 1-5 * * column 3, line 6 - column 4, line 20 * * column 5, line 19 - line 22 * --- | 1-13 | H03G3/32 G11B19/02 G11B33/10 |
| X | US-A-4 754 486 (LARRY E. STAFFORD ET AL.) * claim 1; figure 13 * --- | 1,2 | |
| X | US-A-4 455 677 (SHAFFER W FOX) * column 2, line 5 - line 25; claim 1; figures 1-3 * --- | 1,7,12 | |
| X | US-A-4 491 980 (TERUO ICHIKAWA) * claims 1-3; figures 1-3 * ----- | 1 | |
| | | | **TECHNICAL FIELDS SEARCHED (Int. Cl.5 )** |
| | | | H03G G11B |

The present search report has been drawn up for all claims

| Place of search | Date of completion of the search | Examiner |
|---|---|---|
| BERLIN | 27 APRIL 1992 | BERNAS Y. |

EPO FORM 1503 03.82 (P0401)